# EUROPÄISCHE PATENTANMELDUNG

(11) **EP 1 111 666 A2**
(43) Veröffentlichungstag der Anmeldung: **27.06.2001**
(21) Anmeldenummer: 00890355.1
(22) Anmeldetag: 29.11.2000
(51) Int. Cl.: H01L 21/331

(54) **Verfahren zum Herstellen von Strukturen in Chips**

(30) Priorität: 03.12.1999 AT 84199 U
(71) Anmelder: AUSTRIA MIKRO SYSTEME INTERNATIONAL AKTIENGESELLSCHAFT, A-8141 Unterpremstätten (AT)
(72) Erfinder: Kraft, Jochen, Dr., 8600 Bruck/Mur (AT); Schatzmayr, Martin, Dr., 8043 Graz (AT); Enichlmair, Hubert, Dr., 8044 Graz (AT)
(74) Vertreter: Haffner, Thomas M.

(57) **Zusammenfassung**

Das Verfahren zum Herstellen von Strukturen in Chips, bei welchem eine Folge von Strukturierungsschritten selbstjustierend angewendet wird, wird so durchgeführt, daß durch das Strukturieren einer ersten auf einem Träger aufgebrachten Hilfsschicht nach einer ersten Maskierung eine erste Maskierungsstruktur ausgebildet wird, welche wenigstens einen über die Oberfläche des Trägers vorragenden Teilbereich aufweist, daß nachfolgend ein weiterer Strukturierungsschritt, beispielsweise durch Ätzen, Implantieren oder CVD, unter Verwendung der zuvor hergestellten ersten Maskierungsstruktur als Maske vorgenommen wird und daß anschließend die erste Maskierungsstruktur zur Ausbildung einer zweiten Maskierungsstruktur dadurch invertiert wird, daß auf die erste Maskierungsstruktur wenigsten eine zweite Hilfsschicht aufgebracht, die so gebildete Struktur zumindest teilweise abgetragen und die dadurch freigelegte erste Hilfsschicht selektiv entfernt wird, worauf die zweite Maskierungsstruktur als Maske für einen weiteren Strukturierungsschritt verwendet wird.

## Beschreibung

Die Erfindung betrifft ein Verfahren zum Herstellen von Strukturen in Chips, bei welchem eine Folge von Strukturierungs-schritten selbstjustierend angewendet wird.

In der Halbleiterfertigung sind üblicherweise mehrere aufeinanderfolgende Strukturierungsschritte notwendig, um Halbleiterbauelemente, wie beispielsweise bipolare Transistoren, zu verwirklichen. Jeder einzelne Strukturierungsschritt wird hierbei unter Verwendung einer Maske vorgenommen, wobei jedesmal eine Fotomaske genau ausgerichtet werden muß. Insbesondere muß ab dem zweiten Strukturierungsschritt die Fotomaske genau an der schon vorhandenen Struktur ausgerichtet werden, was bei den immer kleiner werdenden Strukturen in der Halbleiterfertigung hohe Anforderungen an die Justiergenauigkeit stellt. Gleichzeitig muß jedoch der Prozeßablauf möglichst einfach gehalten werden, um die Herstellungskosten möglichst niedrig zu halten.

Die vorliegende Erfindung zielt darauf ab, ein einfaches Verfahren zum Herstellen von Strukturen in Chips zu schaffen, bei welchem ein Ausrichten der Fotomasken und die damit verbundenen Justierprobleme vermieden werden und welches für die Herstellung von kleinen Strukturen geeignet ist. Insbesondere sollen die Strukturierungsschritte selbstjustierend vorgenommen werden und ein einfacher Prozeßablauf gewährleistet sein.

Zur Lösung dieser Aufgabe besteht das erfindungsgemäße Verfahren im wesentlichen darin, daß durch das Strukturieren einer ersten auf einem Träger aufgebrachten Hilfsschicht nach einer ersten Maskierung eine erste Maskierungsstruktur ausgebildet wird, welche wenigstens einen über die Oberfläche des Trägers vorragenden Teilbereich aufweist, daß nachfolgend ein weiterer Strukturierungsschritt, beispielsweise durch Ätzen, Implantieren oder CVD (chemical vapor deposition), unter Verwendung der zuvor hergestellten ersten Maskierungsstruktur als Maske vorgenommen wird und daß anschließend die erste Maskierungsstruktur zur Ausbildung einer zweiten Maskierungsstruktur dadurch invertiert wird, daß auf die erste Maskierungsstruktur wenigsten eine zweite Hilfsschicht aufgebracht, die so gebildete Struktur zumindest teilweise abgetragen und die dadurch freigelegte erste Hilfsschicht selektiv entfernt wird, worauf die zweite Maskierungsstruktur als Maske für einen weiteren Strukturierungsschritt verwendet wird. Dadurch, daß durch das Strukturieren einer ersten auf einen Träger aufgebrachten Hilfsschicht nach einer ersten Maskierung eine Maskierungsstruktur ausgebildet wird, welche wenigstens einen über die Oberfläche des Trägers vorragenden Teilbereich aufweist, wird die Voraussetzung dafür geschaffen, bei nachfolgenden Strukturierungsschritten eine Inversion der Struktur dahingehend vorzunehmen, daß der im ersten Schritt gebildete vorragende Teilbereich abgetragen wird und verbleibende Teile jeweils als Bezugselemente für die Selbstjustierung wirksam werden. Insbesonders wird die Voraussetzung dafür geschaffen, daß bei einem nachfolgend weiteren Strukturierungsschritt, beispielsweise durch Ätzen, Implantieren oder CVD (Chemical vapor deposition), die zuvor hergestellte erste Maskierungsstruktur als Maske eingesetzt werden kann, wobei anschließend an die erste Maskierungsstruktur eine weitere Maskierungsstruktur dadurch hergestellt werden kann, daß die erste Maskierungsstruktur invertiert wird. Die Inversion erfolgt hiebei erfindungsgemäß dadurch, daß auf die erste Maskierungsstruktur wengistens eine zweite Hilfsschicht aufgetragen wird und in der Folge ein zumindest teilweises Abtragen vorgenommen wird. Das Abtragen kann prinzipiell durch Planarisierung erfolgen, wobei eine derartige Planarisierung bisher nur zur Ausbildung von ebenen Oberflächenstrukturen, nicht aber, wie erfindungsgemäß vorgeschlagen, zum Invertieren einer Struktur verwendet wurde. Durch die Planarisierung, welche, wie es einer bevorzugten Weiterbildung entspricht, beispielsweise durch ein chemisch-mechanisches Schleifverfahren und/oder Rückätzverfahren vorgenommen werden kann, wird eine neue Struktur nach der teilweisen Materialabtragung der höher gelegenen Teile des Chip gebildet, bei welcher die erste Maskierungsstruktur, soweit sie noch verblieben ist, wiederum freigelegt wird und in der Folge selektiv entfernt wird. Die nun verbleibenden Teile der zweiten Hilfsschicht bilden eine zweite Maskierungsstruktur, welche als Maske für die weiteren Strukturierungsschritte verwendet wird. Insgesamt ergibt sich durch diese Abfolge von Strukturierungsschritten, bei welcher als wesentlicher Schritt eine Inversion der Struktur unter Verwendung von Planarisierungsverfahren vorgenommen wird, eine besonders einfache Verfahrensweise zur Ausbildung von kleinen Strukturen und insbesondere beispielsweise zur Ausbildung einer hohen Anzahl von Halbleiterschalt- oder Bauelementen, wie beispielsweise bipolaren Transistoren, auf der Oberfläche des Chips, sodaß eine höhere Bauteildichte bei gleichzeitig erhöhter Präzision der jeweiligen Schichtgrenzen erzielt werden kann.

Wie bereits erwähnt erfolgt das Abtragen bevorzugt durch ein chemisch-mechanisches Schleifverfahren oder durch Rückätzverfahren. Im Falle der Verwendung von Rückätzverfahren für die Planarisierung zur Invertierung der Struktur wird mit Vorteil so vorgegangen, daß auf die erste Maskierungsstruktur zusätzlich zur zweiten Hilfsschicht eine Planarisierungsschicht aus einem Material aufgebracht wird, das gute Planarisierungseigenschaften besitzt. Die Planarisierungsschicht bildet in tiefer gelegenen Bereichen eine dickere Schicht als über den höhereren Chipteilen. Ätzt man nun gleichmäßig mit einer idealerweise gleichen Ätzrate für die Planarisierungsschicht und die höher gelegenen Strukturen, so überträgt sich die Topographie der planarisierten Schichtoberflächeauf die Chipoberfläche. Auf diese Weise wird sichergestellt, daß die gewünschte Inversion der Struktur mit hoher Präzision erreicht wird.

Mit Vorteil wird erfindungsgemäß so vorgegangen, daß die zweite Hilfsschicht und gegebenenfalls die Planarisierungsschicht nicht planarisierend wird. Ein nicht planarisierendes Ätzen hat hiebei den Vorzug, daß die Materialabnahme gerichtet und in erster Linie vertikal erfolgt, wobei ein derartiges nicht planarisierendes Ätzen insbesondere für die Ausbildung von Abstandshaltern und damit für die Zwecke der Selbstjustierung von besonderem Vorteil ist. In bevorzugter Weise wird daher im Rahmen des Verfahrens so vorgegangen, daß auf die erste und/oder die zweite Maskierungsstruktur eine Schicht aufgebracht wird, welche anschließend zur Ausbildung eines Abstandhalters anisotrop geätzt wird. Durch Wahl der Stärke der auf die erste und/oder auf die zweite Maskierungsstruktur aufgebrachten Schicht wird in der Folge die Präzision der Justierung gewährleistet, da die verbleibenden Abstandhalter eine Stärke in Richtung der Oberfläche gemessen aufweisen, welche im wesentlichen der Stärke der aufgebrachten Schicht entspricht.

Prinzipiell ist für die Auswahl der einzelnen Schichten in erster Linie das Kriterium maßgebend, daß jeweils abzutragende Schichten mit hoher Selektivität gegenüber nicht abzutragenden Schichten entfernt werden können. Es soll somit eine gute Selektivität für die jeweils sukzessive aufgetragenen Schichten und Hilfsschichten bzw. gegenüber dem Spacermaterial bestehen. Pinzipiell können hiebei alle üblichen und gebräuchlichen Schichten und Hilfsschichten, beispielsweise Polysilizium, Siliziumoxyd, Polymere, Silizide wie z.B. Titansilizid, Wolframsilizid oder dgl., Nitride und Metallschichten, wie beispielsweise Titan-, Aluminium- oder dgl. -schichten zum Einsatz gelangen.

Mit Vorteil wird erfindungsgemäß so vorgegangen, daß die erste Maskierungsstruktur aus Siliziumnitrid besteht, sodaß in der Folge eine einfache Abtragung dieser Schicht mit konventionellen Methoden, beispielsweise mittels heißer Phosphorsäure gelingt. Mit Vorteil wird weiters die zweite Maskierungsstruktur aus Siliziumoxid ausgebildet und die Planarisierungsschicht aus einem organischen Polymer. Die Abtragung organischer Polymere kann durch thermische Verfahren und beispielsweise auch durch Plasmaätzen erfolgen, wobei Schichten aus Siliziumoxyd oder polykristallinem Silizium bei einem derartigen selektiven Abtrageschritt nicht verändert werden.

Mit Vorteil kann auch die zweite Hilfsschicht aus einem organischen Polymer bestehen, wobei in diesem Fall die selektive Entfernung dieser Planarisierungsschicht gegenüber den übrigen Schichten gleichfalls gewährleistet ist.

Wenn ein Trägermaterial zum Einsatz gelangt, welches keine Ätzselektivität gegenüber nachfolgend aufzubringenden Schichten aufweist, wird mit Vorteil so vorgegangen, daß der Träger selbst eine dritte Hilfsschicht ist, die aus einem Material mit guter Ätzselektivität zur ersten und zweiten Maskierungsstruktur besteht.

Die Abscheidung der jeweiligen Schichten kann mit konventionellen Verfahren erfolgen. Mit Vorteil wird eine zweite Hilfsschicht mittels eines CVD-Verfahrens aufgebracht, wobei die zweite Hilfsschicht auch aus einem organischen Polymer bestehen kann, das mit einem Spin-Verfahren aufgebracht wird.

Das erfindungsgemäße Verfahren eignet sich bevorzugt für die Ausbildung von Bipolartransistoren, wobei aufgrund der hohen Präzision die elektrischen Parameter des Transistors exakter eingestellt werden können.

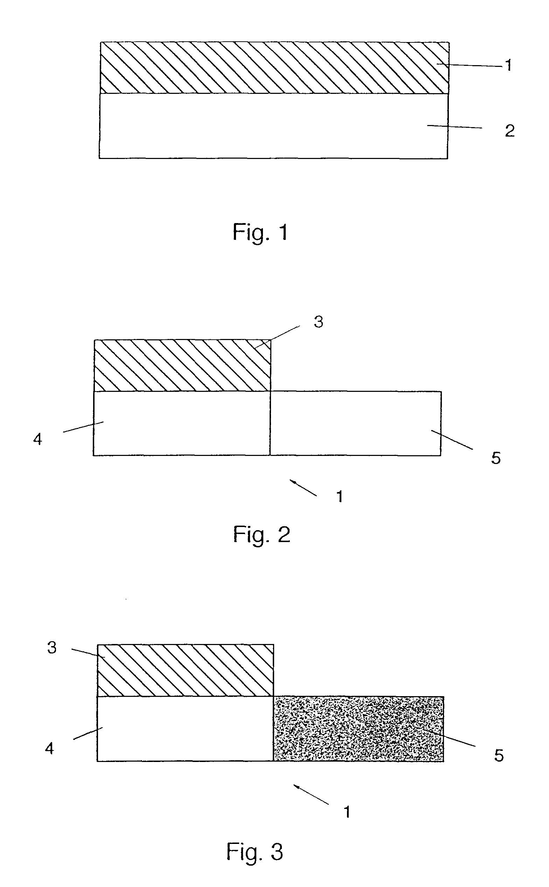

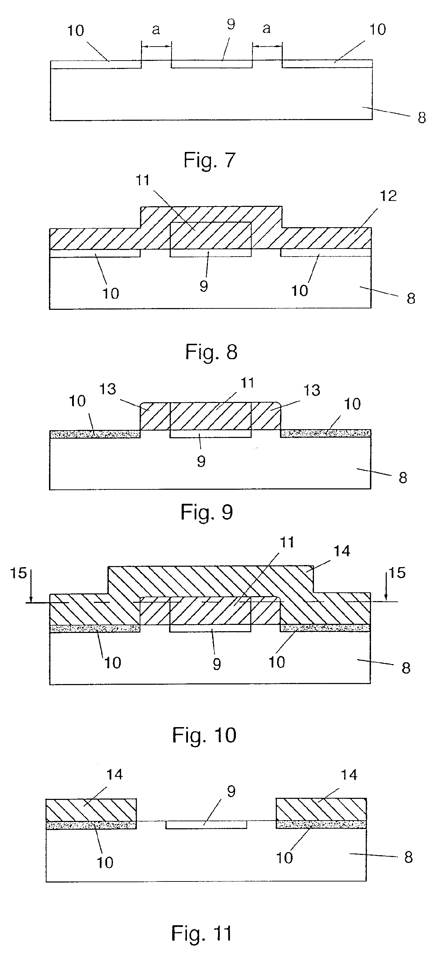

Die Erfindung wird nachfolgend anhand von in der Zeichnung schematisch erläuterten Ausführungsbeispieles näher erläutert. In dieser zeigen Fig. 1 bis 6 eine schematische Darstellung des erfindungsgemäßen Verfahrens und Fig. 7 bis 11 eine Anwendung des erfindungsgemäßen Verfahrens zur Herstellung von Bipolartransistoren.

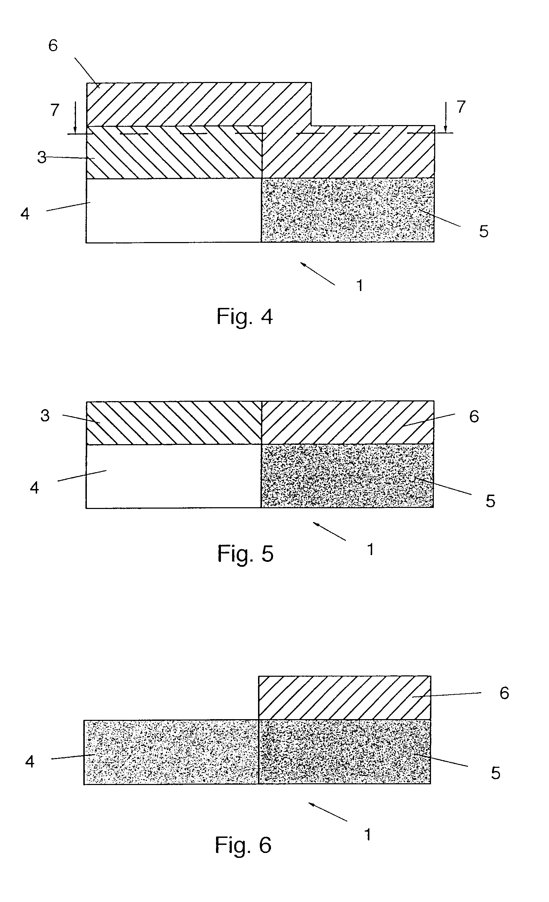

In Fig. 1 ist mit 1 ein Halbleitersubstrat bezeichnet, auf welches eine erste Hilfsschicht 2 aufgebracht ist. Durch geeignete Maskierung der ersten Hilfsschicht 2 wird nun eine erste Maskierungsstruktur 3 ausgebildet, welche einen Bereich 4 des Halbleitersubstrats 1 bedeckt und einen weiteren Bereich 5 des Halbleitersubstrats 1 unbedeckt läßt, wie dies in Fig. 2 dargestellt ist. Der unmaskierte Bereich 5 kann in der Folge, beispielsweise durch Implantieren, strukturiert werden, wie dies in Fig. 3 dargestellt ist. Die erste Maskierungsstruktur 3 muß die übrigen Chipaufbauten hierbei soweit überragen, daß bei dem später folgenden Planarisierungsschritt gezielt diese Strukturen abgetragen werden können. Fig. 4 zeigt wie die Inversion der Maskierungsstruktur 3 vorbereitet wird. Zunächst wird eine zweite Hilfsschicht 6 auf die erste Maskierungsstruktur 3 sowie auf den unmaskierten Bereich 5 des Halbleitersubstrats 1 aufgebracht, worauf das gesamte die Ebene 7 überragende Material durch Planarisierungsverfahren abgetragen wird. Dadurch wird gleichzeitig die Maskierungsstruktur 3 freigelegt und eine selektive Maskierung des Bereiches 5 des Halbleitersubstrats 1 durch die zweite Hilfsschicht 6 erreicht, wie dies in Fig. 5 dargestellt ist. Die freigelegte Maskierungsstruktur 3 kann nun, beispielsweise durch Ätzen, selektiv entfernt werden, sodaß lediglich die zweite Hilfsschicht 6 verbleibt, welche der invertierten Struktur der Maskierung 3 entspricht und als Maskierungsstruktur für eine nachfolgende Strukturierung des Bereiches 4 des Halbleitersubstrates 1 dient. Fig. 6 zeigt, daß die zweite Maskierungsstruktur 6 exakt den bereits strukturierten Bereich des Halbleitersubstrats bedeckt, sodaß nun selektiv der Bereich 4 bearbeitet werden kann. Es ergibt sich somit, daß ausgehend von einer ersten Maskierungsstruktur 3 durch eine Abfolge einfacher Verfahrensschritte eine zweite Maskierungsstruktur 6 ausgebildet werden kann, welche exakt an der ersten Maskierungsstruktur ausgerichtet ist.

In den Fig. 7 bis 11 ist nun die Anwendung des erfindungsgemäßen Verfahrens auf die Herstellung eines Bipolartransistors gezeigt. Bei Bipolartransistoren stellt sich das Problem, daß ein intrinsischer Basisbereich und ein Emitterbereich zentral strukturiert werden muß. Seitlich dieses zentralen Bereiches muß, unter Einhaltung eines definierten Abstandes, die Basiszuleitung strukturiert werden (z.B. durch einen Implantschritt oder durch das Aufwachsen eines Silizids). Diese beiden Strukturierungsschritte müssen exakt aufeinander ausgerichtet werden. Ein zu großer Abstand bedeutet, daß der Widerstand der Basiszuleitung zunimmt, ein zu kleiner Abstand bzw. ein Überlappen hat zur Folge, daß der Basisbereich teilweise hoch dotiert wird bzw. daß der Emitter kurzgeschlossen wird. In Fig. 7 ist das Halbleitersubstrat, in welchem bereits der Kollektor enthalten ist, mit 8 bezeichnet. In einem Bereich 9 soll nun der intrinsische Basisbereich und seitlich davon, jeweils unter Einhaltung eines Abstandes a, extrinsische Bereiche 10 für die Basiszuleitung ausgebildet werden. Hierfür wird zunächst eine erste Maskierungsstruktur 11 aufgebracht, welche den intrinsischen Basisbereich abdeckt, wie dies in Fig. 8 dargestellt ist. Nachfolgend wird eine Schicht 12 eines Spacermaterials aufgebracht, deren Dicke genau dem Abstand a zwischen intrinsischer und extrinsischer Basis entspricht. Durch anisotropes Ätzen der Spacerschicht 12 werden Abstandhalter 13 ausgebildet, sodaß nun, wie in Fig. 9 dargestellt ist, die extrinsischen Bereiche, beispielsweise mit Bor, dotiert werden können. Anschließend wird eine Hilfsschicht 14 auf die erste Maskierungsstruktur 11, die Abstandshalter sowie über die freiliegende Substratoberfläche aufgebracht, sodaß nun die in Fig. 10 dargestellte Struktur entsteht. Das über die Ebene 15 hervorragende Material wird durch Planarisierungsverfahren abgetragen, sodaß die Maskierungsstruktur 11 freigelegt wird, worauf diese durch selektives Ätzen entfernt wird. Die dadurch entstehende in Fig. 11 gezeigte Maskierungsstruktur 14 ermöglicht nun das selektive Dotieren des Kollektorbereiches unter dem intrinsischen Basisbereich 9 mit dem sogenannten SIC-Implantat (SIC = selektive implanted collector). Darüber hinaus kann man mit Hilfe der Maskierungsstruktur 14 den Bereich über der intrinsischen Basis freilegen, in den das Emitterpolysilizium abgeschieden wird. Das erfindungsgemäße Prinzip der Strukturinversion kann für konventionelle BJTs (BJT = bipolar junction transistor, bipolarer Sperrschicht Transistor) mit implantierter Basis als auch für Bipolartransistoren mit epitaktisch aufgewachsener Basis mit NPN oder PNP-Polarität angewendet werden.

## Patentansprüche

1. Verfahren zum Herstellen von Strukturen in Chips, bei welchem eine Folge von Strukturierungsschritten selbstjustierend angewendet wird, dadurch gekennzeichnet, daß durch das Strukturieren einer ersten auf einem Träger aufgebrachten Hilfsschicht nach einer ersten Maskierung eine erste Maskierungsstruktur ausgebildet wird, welche wenigstens einen über die Oberfläche des Trägers vorragenden Teilbereich aufweist, daß nachfolgend ein weiterer Strukturierungsschritt, beispielsweise durch Ätzen, Implantieren oder CVD, unter Verwendung der zuvor hergestellten ersten Maskierungsstruktur als Maske vorgenommen wird und daß anschließend die erste Maskierungsstruktur zur Ausbildung einer zweiten Maskierungsstruktur dadurch invertiert wird, daß auf die erste Maskierungsstruktur wenigsten eine zweite Hilfsschicht aufgebracht, die so gebildete Struktur zumindest teilweise abgetragen und die dadurch freigelegte erste Hilfsschicht selektiv entfernt wird, worauf die zweite Maskierungsstruktur als Maske für einen weiteren Strukturierungsschritt verwendet.

2. Verfahren nach Anspruch 1, dadurch gekennzeichnet, daß die Abtragung durch Planarisierung beispielsweise ein chemisch-mechanisches Schleifverfahren vorgenommen wird.

3. Verfahren nach Anspruch 2, dadurch gekennzeichnet, daß das Abtragen durch ein Rückätzverfahren vorgenommen wird.

4. Verfahren nach Anspruch 3, dadurch gekennzeichnet, daß auf die erste Maskierungsstruktur zusätzlich zur zweiten Hilfsschicht eine Planarisierungsschicht aus einem Material aufgebracht wird, das gute Planarisierungseigenschaften besitzt.

5. Verfahren nach Anspruch 3 oder 4, dadurch gekennzeichnet, daß die zweite Hilfsschicht und gegebenenfalls die Planarisierungsschicht nicht planarisierend geätzt wird.

6. Verfahren nach einem der Ansprüche 1 bis 5, dadurch gekennzeichnet, daß auf die erste und/oder die zweite Maskierungsstruktur eine Schicht aufgebracht wird, welche anschließend zur Ausbildung eines Abstandhalters anisotrop geätzt wird.

7. Verfahren nach einem der Ansprüche 1 bis 6, dadurch gekennzeichnet, daß die erste Maskierungsstruktur aus Siliziumnitrid besteht.

8. Verfahren nach einem der Ansprüche 1 bis 7, dadurch gekennzeichnet, daß die zweite Maskierungsstruktur aus Siliziumoxid besteht.

9. Verfahren nach einem der Ansprüche 1 bis 7, dadurch gekennzeichnet, daß die zweite Hilfsschicht aus einem organischen Polymer besteht.

10. Verfahren nach einem der Ansprüche 4 bis 9, dadurch gekennzeichnet, daß die Planarisierungsschicht aus einem organischen Polymer besteht.

11. Verfahren nach einem der Ansprüche 1 bis 10, dadurch gekennzeichnet, daß der Träger eine dritte Hilfsschicht ist, die aus einem Material mit guter Ätzselektivität zur ersten und zweiten Maskierungsstruktur besteht.

12. Verfahren nach einem der Ansprüche 1 bis 11, dadurch gekennzeichnet, daß die zweite Hilfsschicht mittels eines CVD-Verfahrens aufgebracht wird.

13. Verfahren nach einem der Ansprüche 1 bis 12, dadurch gekennzeichnet, daß die Schichten zur Ausbildung eines Bipolartransistors aufgebracht und behandelt werden.
